# EUROPÄISCHE PATENTSCHRIFT

(11) **EP 1 562 755 B1**
(45) Veröffentlichungstag und Bekanntmachung des Hinweises auf die Patenterteilung: **14.09.2011**
(21) Anmeldenummer: 03785525.1
(22) Anmeldetag: 20.11.2003
(51) Int. Cl.: B41M 3/00, B41M 3/14, B41M 5/24, G03F 1/00, B32B 15/04, B32B 15/08, H05K 3/06, H05K 3/08, H05K 3/12

(54) **VERFAHREN ZUR HERSTELLUNG EINES PARTIELL METALLISIERTEN FOLIENELEMENTS**
METHOD FOR PRODUCING A PARTIALLY METALLISED FILM-TYPE ELEMENT
PROCEDE POUR PRODUIRE UN ELEMENT DE TYPE FEUILLE PARTIELLEMENT METALLISE

(30) Priorität: 20.11.2002 DE 10254029
(43) Veröffentlichungstag der Anmeldung: 17.08.2005
(73) Patentinhaber: Leonhard Kurz Stiftung & Co. KG, 90763 Fürth (DE)
(72) Erfinder: BREHM, Ludwig, 91325 Adelsdorf (DE); WILD, Heinrich, 91074 Herzogenaurach (DE); THÄTER, Mathias, 91126 Schwabach (DE)
(74) Vertreter: Zinsinger, Norbert
(86) Internationale Anmeldenummer: PCT/DE2003/003847
(87) Internationale Veröffentlichungsnummer: WO 2004/045859

(56) Entgegenhaltungen:
- EP-A- 0 107 983
- EP-A- 0 790 123
- WO-A-99/13157
- DE-A- 2 553 385
- GB-A- 1 152 033
- US-A- 4 242 378
- US-A- 4 517 045
- US-A- 4 610 755
- US-A- 5 090 121
- US-A- 5 470 644
- DATABASE WPI Section Ch, Week 198838 Derwent Publications Ltd., London, GB; Class L03, AN 1988-267299 XP002277204 -& JP 63 194388 A (TOYODA AUTOMATIC LOOM CO LTD), 11. August 1988 (1988-08-11)

## Beschreibung

Die Erfindung betrifft ein Verfahren und eine Einrichtung zur Herstellung eines partiell metallisierten Folienelements, insbesondere einer Prägefolie, einer Laminierfolie oder eines optisch variablen Sicherungselements und ein partiell metallisiertes Folienelement, insbesondere eine Prägefolie, eine Laminierfolie oder ein optisch variables Sicherungselement.

Die WO 99/13157 beschreibt eine partiell metallisierte Sicherheitsfolie für Wertpapiere und ein Verfahren zur Herstellung einer solchen Folie. Eine solche Sicherheitsfolie zur Einlagerung oder Aufbringung in bzw. auf Wertpapieren besteht aus einer transluzenten Trägerfolie und einer darauf aufgebrachten metallischen Beschichtung, die metallfreie Bereiche aufweist. Zur Herstellung dieser partiell metallisierten Folie wird eine Trägerfolie partiell mittels eines Tiefdruckverfahrens mit einer Druckfarbe mit hohem Pigmentanteil bedruckt und dann die Druckfarbe zur Bildung eines porigen, erhabenen Farbauftrages getrocknet. Auf der so bedruckten Trägerfolie wird dann eine dünne metallische Abdeckschicht gebildet. Anschließend wird die über dem Farbauftrag liegende oder in den Farbauftrag eingedrungene Abdeckschicht durch Auswaschen mit einer Flüssigkeit, eventuell kombiniert mit mechanischer Einwirkung entfernt. Anschließend wird die Trägerfolie getrocknet und gegebenenfalls zugeschnitten. Auf der Trägerfolie verbleibt somit in den ursprünglich nicht mit Druckfarbe versehenen Bereichen die metallische Abdeckschicht, die eine Dicke von 0,01 µm bis 1 µm besitzen kann.

In der WO 02/31214 A1 ist eine weitere Möglichkeit aufgezeigt, eine partiell metallisierte Folie herzustellen. Bei diesem Verfahren wird zunächst ein Trägermaterial gereinigt und bekeimt. Dieser Verfahrensschritt ist Voraussetzung für eine gute Haftung der partiell strukturierten Metallschicht auf dem Trägermaterial.

Vor dem Aufbringen der eigentlichen funktionellen Schicht wird eine in einem beliebigen Lösungsmittel, z.B. Wasser, Alkohol, Ketone oder Ester, lösliche Farbe mittels eines Tiefdruckverfahrens aufgebracht. Anschließend wird ein Reinigungs- und Bekeimungsschritt durchgeführt:

Das bedruckte Substrat wird mittels eines INLINE Plasma- oder Coronaprozesses behandelt. Durch diese Behandlung wird die Folienoberfläche von Tonungsresten der Druckfarben befreit und gleichzeitig aktiviert, da endständige polare Gruppen erzeugt werden. Darüberhinaus wird zeitgleich mit der Plasmavorbehandlung im Vakuum auch eine dünne Metall- oder Metalloxidschicht als Haftvermittler durch Sputtern oder Aufdampfen aufgebracht. Hierzu eignen sich insbesondere Cr, Al, Ag, Ni, Cu, Ti, TiO₂, SiOₓ, CrOₓ.

Anschließend wird eine Cu-Schicht zur Bildung der Musterschicht auf der Trägerfolie aufgebracht. Dann wird die Farbe durch einen mechanischen Waschvorgang entfernt, um die gewünschte Strukturierung zu erhalten. Darauf folgt eine galvanische Nachverstärkung dieser Musterschicht unter Bildung einer metallischen Verstärkungsschicht auf der Musterschicht.

Das Dokument US-A-4242378 beschreibt ein Verfahren zur Herstellung einer partiell metallisierten Folie bei dem eine Waschmaske zur partiellen Abdeckung des Folienkörpers durch Aufdrucken (z.B. durch Siebdruck oder Tiefdruck) aufgetragen wird, der Folienkörper anschließend getrocknet, mit der Metallschicht versehen und die Metallschicht durch ein Waschverfahren im Bereich der Waschmaske partiell entfernt wird.

Der Erfindung liegt nun die Aufgabe zugrunde, ein besonders kostengünstig hergestelltes partiell metallisiertes Folienelement, insbesondere eine partiell metallisierte Prägefolie oder Laminierfolie zur Verfügung zu stellen.

Diese Aufgabe wird durch ein Verfahren zur Herstellung eines partiell metallisierten Folienelements gemäß Anspruch 1 gelöst.

Die Erfindung kann hierbei nicht nur für die Herstellung von Prägefolien oder Laminierfolien verwendet werden, sondern auch für die Herstellung beliebiger Arten von dekorativen oder funktionellen Folien verwendet werden, die eine partiell ausgeformte Metallschicht aufweisen. Ein Beispiel hierfür sind Inmold-Folien, die zur Dekoration von dreidimensionalen Gegenständen mittels des Inmold-Verfahrens verwendet werden.

Weiter ist die Erfindung zur Herstellung eines optisch variablen Sicherheitselementes einsetzbar, das mittels eines Transferverfahrens auf ein Sicherheitsprodukt, beispielsweise auf eine Banknote, eine Kreditkarte, eine Geldkarte oder ein Dokument aufgebracht werden kann. Weiter besteht die Möglichkeit dieses optisch variable Element als Sicherheits- oder Echtheitskennzeichnung auf einem Gegenstand, beispielsweise auf einer CD oder auf einer Verpackung, aufzubringen.

Durch die Erfindung wird der Vorteil erreicht, daß sich die Herstellung von partiell metallisierten Folienelementen weitgehend automatisieren läßt und somit zum einen die Geschwindigkeit des Herstellungsprozesses erhöht wird und zum anderen die Kosten des Herstellungsprozesses gesenkt werden.

Weiter kann bei diesem Verfahren auf den Einsatz von teueren Werkzeugen wie beispielsweise Tiefdruckrasterwalzen verzichtet werden. Es kann flexibler auf Produktionsänderungen reagiert werden, wodurch die Kosten des Herstellungsprozesses weiter sinken. Weitere Vorteile ergeben sich im Bereich von Sicherheitsanwendungen. Die Herstellung einer Tiefdruckrasterwalze erfordert die Beteiligung eines spezialisierten Zulieferbetriebes.

Weitere Vorteile ergeben sich dadurch, daß eine Individualisierung von Folienelementen durch Veränderungen des digitalen Datensatzes auf einfache Art und Weise erreicht werden kann. Hierdurch ergeben sich insbesondere Vorteile für Kleinserien und bild- und datenvariable Informationen.

Eine Kostenersparnis ergibt sich weiter dadurch, daß keine Repro benötigt wird und Arbeitsvorgänge der Druckvorstufen entfallen.

Vorteilhafte Ausgestaltungen der Erfindung sind in den Unteransprüchen bezeichnet.

Es ist zweckmäßig, einen Foliengrundkörper zuerst mit einer Metallschicht zu versehen und sodann mit dem Werkzeug digital gesteuert ein Ätzmittel zur partiellen Demetallisierung der Metallschicht auf die Metallschicht aufzutragen. Nach der partiellen Demetallisierung wird das Ätzmittel entfernt. Alternativ ist es möglich, den Foliengrundkörper mit einer Metallschicht zu versehen und dann mit dem Werkzeug digital gesteuert einen Ätzresist zur partiellen Abdeckung der Metallschicht aufzutragen. Die nicht abgedeckte Metallschicht wird sodann durch Demetallisierung entfernt. Weiter ist es möglich, mit dem Werkzeug digital gesteuert eine Waschmaske zur partiellen Abdeckung des Folienkörpers auf den Foliengrundkörper aufzutragen und den Folienkörper erst anschließend mit einer Metallschicht zu versehen. Die Metallschicht wird sodann durch ein Waschverfahren im Bereich der Waschmaske partiell entfernt.

Diese oben beschriebenen Varianten zeichnen sich durch eine hohe Bearbeitungsgeschwindigkeit aus. Weiter sind die zur Durchführung dieser Verfahren erforderlichen Verfahrensschritte einfach in bereits bestehende Herstellungsverfahren für partiell metallisierte Folienelemente integrierbar bzw. mit derartigen Verfahren kombinierbar. Daraus können sich je nach gegebener Problemstellung weitere Kostenvorteile ergeben.

Es ist ebenfalls vorteilhaft, den Foliengrundkörper mit einer Metallschicht zu versehen und anschließend die Metallschicht durch das Werkzeug mittels Funkenerosion zu entfernen.

Durch eine derartige Vorgehensweise ergeben sich Kostenvorteile, da der Einsatz von Ätzmitteln, Ätzresist usw. vermeidbar ist. Im weiteren wird die Anzahl der notwendigen Verfahrensschritte reduziert, so daß sich die Herstellungszeit der Folienelemente verkürzt.

Als besonders vorteilhaft hat es sich erwiesen, daß als Werkzeug ein Karbonstift gemäß der Werkzeugbahn über den ein- oder mehrschichtigen Folienkörper bewegt wird und daß gemäß den Steuerdaten eine Potentialdifferenz zwischen dem Karbonstift und einem Masse-Kontakt-Element zur partiellen Erosion der Metallschicht erzeugt wird. Für die Erosion einer aus Aluminium bestehenden Metallschicht werden hierbei besonders gute Ergebnisse bei einer Potentialdifferenz von 3 bis 4 V und für die Erosion einer aus Chrom bestehenden Metallschicht werden besonders gute Ergebnisse bei eine Potentialdifferenz von etwa 6 V erzielt.

Besonders gute Verarbeitungsergebnisse lassen sich weiter dadurch erzielen, daß die Anordnung von Karbonstift und Masse-Kontakt-Element bei der Berechnung der Werkzeugbahn und/oder der Steuerdaten berücksichtigt wird.

Weiter hat es sich als zweckmäßig erwiesen, daß das Werkzeug die Metallschicht partiell mittels eines Laserstrahls erodiert.

Das Werkzeug kann hierbei das Ätzmittel, den Ätzresist oder die Waschmaske mittels einer Rolle auf den Folienkörper auftragen. Weiter ist es auch möglich, daß das Werkzeug, das Ätzmittel, den Ätzresist oder die Waschmaske mittels Aufspritzen auf den Folienkörper aufträgt.

Es hat sich erwiesen, daß das erfindungsgemäße Verfahren besonders gut für die Herstellung von partiellen Metallschichten geeignet ist, die eine Dicke kleiner als 1 µm besitzen.

Ein vollflächiges Aufbringen der Metallschicht auf den Folienkörper bringt den Vorteil mit sich, daß besonders einfache und kostengünstige Verfahren wie beispielsweise ein Aufdampfen der Metallschicht Verwendung finden können. Aber auch ein teilflächiges, partielles Aufbringen der Metallschicht (z. B. durch Aufdrucken von Metallpigmenten) kann für bestimmte Anwendungsfälle Vorteile mit sich bringen. So ist es möglich, nur solche Bereiche mit einer Metallschicht zu versehen, für die auch tatsächlich später im wesentlichen die Metallisierung erhalten bleiben soll. Unter Umständen ist es mit einem solchen partiellen Aufbringen der Metallschicht möglich, die Bearbeitungszeit weiter zu beschleunigen und erhebliche Mengen von Ätzmittel, Ätzresist und dergleichen einzusparen.

Im folgenden wird die Erfindung anhand von mehreren Ausführungsbeispielen unter Zuhilfenahme der beiliegenden Zeichnung beispielhaft verdeutlicht.
- Fig. 1: zeigt einen schematischen Querschnitt durch ein partiell metallisiertes Folienelement.
- Fig. 2: zeigt eine schematische Darstellung eines Herstellungsverfahrens.
- Fig. 3: zeigt ein Blockschaltbild einer Einrichtung zur Herstellung eines partiell demetallisierten Folienelements.
- Fig. 4a bis: zeigen schematische Querschnitte durch Folienelemente zur
- Fig. 4d: Verdeutlichung eines Herstellungsverfahrens.
- Fig. 5: zeigt eine schematische Darstellung eines Herstellungsverfahrens.
- Fig. 6a bis Fig. 6c: zeigen schematische Querschnitte durch Folienelemente zur Verdeutlichung eines Herstellungsverfahrens.
- Fig. 7: zeigt eine schematische Darstellung eines Herstellungsverfahrens.
- Fig. 8a bis Fig. 8c: zeigen schematische Querschnitte durch Folienelemente zur Verdeutlichung eines Herstellungsverfahrens.
- Fig. 9: zeigt eine schematische Darstellung eines Herstellungsverfahrens.

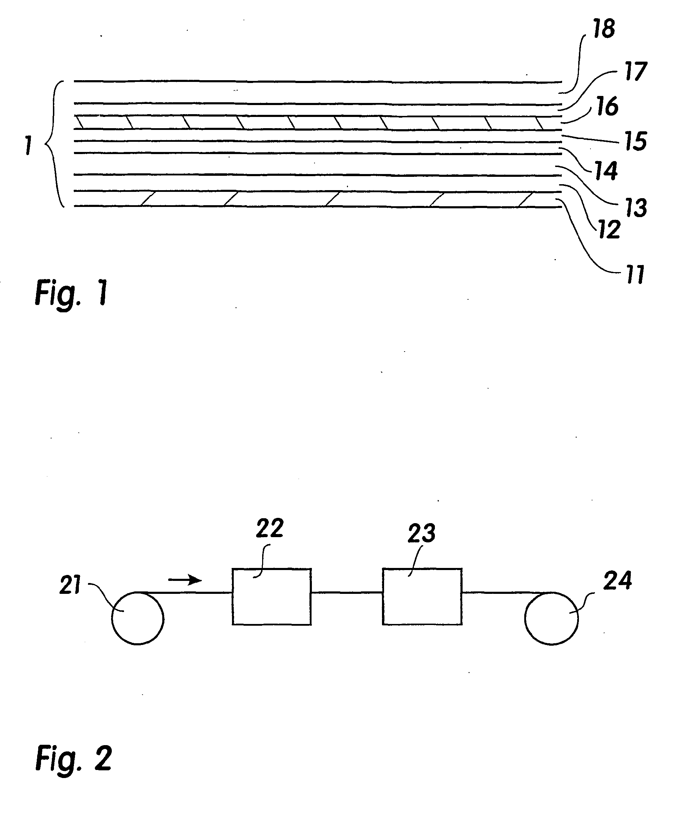

Fig. 1 zeigt ein Folienelement 1, das eine Trägerschicht 11, eine Schutzlack- und /oder Ablöseschicht 12, eine Replizierschicht 13, eine Absorptionsschicht 14, eine Distanzschicht 15, eine partielle Reflexionsschicht 16, eine Haftvermittlungsschicht 17 und eine Klebeschicht 18 aufweist.

Bei dem Folienelement 1 handelt es sich um eine Prägefolie, insbesondere um eine Heißprägefolie, mittels der ein von den Schichten 12 bis 18 gebildetes dekoratives Element aufgebracht wird.

Die Trägerschicht 11 besteht beispielsweise aus PET. Sie dient dem fertigungstechnischen Aufbringen des optisch variablen Elements auf das zu sichernde Objekt und wird bestimmungsgemäß nach dem Aufbringen des optisch variablen Elements auf das zu sichernde Objekt entfernt.

Die Replizierschicht 13 besteht aus einem thermoplastischen Kunststoff. In die Replizierschicht 13 werden mittels eines Prägewerkzeuges ein oder mehrere diffraktive Strukturen in den thermoplastischen Kunststoff der Replizierschicht 13 eingeprägt. Bei diesen diffraktiven Strukturen handelt es sich vorzugsweise um Strukturen, die mittels Beugungseffekten Hologramme und dergleichen erzeugen. Es ist jedoch auch möglich, daß anstelle von diffraktiven Strukturen Mattstrukturen, Makrostrukturen, achromatisch-symmetrische Strukturen, beispielsweise Sinusgitter, achromatisch-asymmetrische Strukturen, beispielsweise Blaze-Strukturen oder Kineforms, in die Schicht 13 eingeprägt werden.

Die Schichten 14, 15 und 16 bilden eine Dünnfilmschichtfolge, die mittels Interferenz blickwinkelabhängige Farbverschiebungen erzeugt. Neben der in Fig. 1 dargestellten Möglichkeit, eine derartige Dünnfilmschichtfolge aus einer Absorptionsschicht (vorzugsweise mit 30 bis 50 % Transmission), einer transparenten Distanzschicht als Farbwechsel erzeugenden Schicht (λ/4 oder λ/2 Schicht) und einer reflektierenden Schicht aufzubauen, ist es auch möglich, eine derartige Dünnfilmschichtfolge aus einer Abfolge von hoch- und niedrigbrechenden Schichten aufzubauen. Bei einem derartigen Schichtaufbau kann auf die Verwendung einer Absorptionsschicht verzichtet werden.

Die Reflexionsschicht 16 wird von einer partiellen Metallschicht gebildet. Die Reflexionsschicht 16 kann aus einem der folgenden Metalle oder aus einer Legierung der folgenden Metalle bestehen: Cr, Al, Ag, Ni, Cu, Ti. Die Reflexionsschicht 16 wird hierbei mittels eines der Verfahren nach den Figuren 2 bis 9 hergestellt.

Auf die Schichten 12, 13, 14 und 15 und auf die Schicht 17 könnte hierbei auch verzichtet werden. Weiter ist es auch möglich, daß das Folienelement 1 eine Laminierfolie ist und anstelle der Trägerschicht 11 und der Schutz- und/oder Ablöseschicht 12 eine Haftvermittlungsschicht aufweist.

Fig. 2 zeigt eine Fabrikationseinrichtung zur Erzeugung eines partiell metallisierten Folienelements. Die Fabrikationseinrichtung weist zwei Folienrollen 21 und 24, eine Metallisierungsstation 22 und eine Demetallisierungsstation 23 auf.

Die Metallisierungsstation 22 beschichtet einen ihr zugeführten Folienkörper mit einer dünnen Metallschicht. Hierbei führt die Metallisierungsstation 22 vorzugsweise eine vollflächige Beschichtung des zugeführten Folienkörpers mittels Bedampfung durch. Es ist jedoch auch möglich, daß die Metallisierungsstation 22 nur eine partielle Metallisierung der Folie durchführt, indem sie beispielsweise mittels einer Bedampfungsmaske Teile des zugeführten Folienkörpers abdeckt.

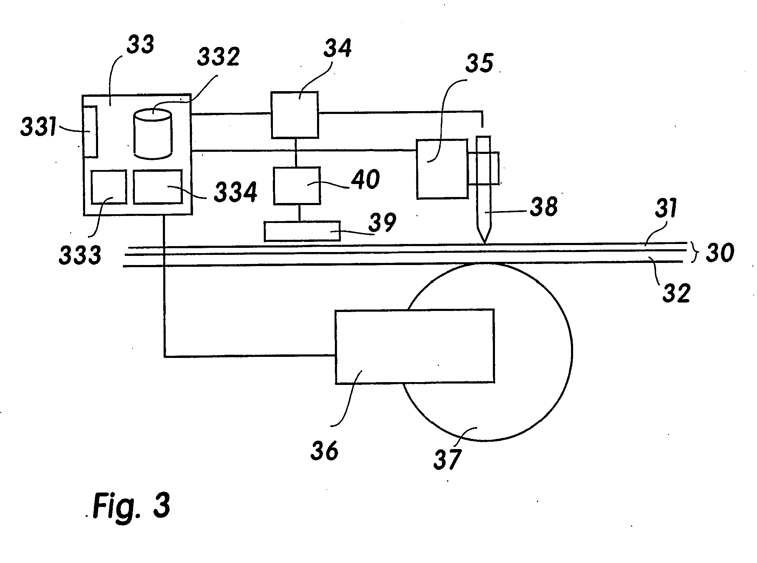

Der derart mit einer dünnen Metallschicht versehene Folienkörper wird der Demetallisierungsstation 23 zugeführt, die eine digitale Demetallisierung von partiellen Bereichen der Metallschicht durchführt. Die Demetallisierungsstation 23 ist hierbei gemäß der Einrichtung nach Fig. 3 ausgestaltet.

Es ist möglich, daß die in Fig. 2 dargestellte Fabrikationseinrichtung noch weitere Bearbeitungsstationen umfaßt, die beispielsweise zur Herstellung der Schichten 12 bis 15 und 17 bis 18 nach Fig. 1 dienen. Weiter kann der Herstellungs-Prozeß auch als diskontinuierlicher Prozeß ausgestaltet sein, so daß zwischen einer oder mehreren dieser Stationen die Folie aufgerollt und zwischengelagert wird.

Fig. 3 zeigt eine Einrichtung zur Herstellung eines partiell metallisierten Folienelements, die eine Steuereinrichtung 33, eine Spannungsquelle 40, ein Masse-Kontakt-Element 39, ein Schaltungselement 34, einen Karbonstift 38, eine Rolle 37 und zwei Führungseinrichtungen 35 und 36, umfaßt.

Weiter zeigt Fig. 3 einen mehrschichtigen Folienkörper 30, der aus einem Foliengrundkörper 32 und einer Metallschicht 31 besteht. Der Foliengrundkörper 32 könnte beispielsweise von den Schichten 11 bis 15 nach Fig. 1 gebildet werden.

Die Steuereinrichtung 33 besteht aus einen oder mehreren Mikroprozessoren, Speicherelementen und peripheren Baugruppen und aus auf dieser Hardwareplattform aufsetzenden Steuerprogrammen. Bei der Ausführung dieser Steuerprogramme auf der Hardwareplattform werden die im Folgenden beschriebenen Funktionen der Steuereinrichtung 33 erbracht:

Aus funktioneller Sicht umfaßt die Steuereinrichtung 33 einen Datenspeicher 332, eine Eingabeeinheit 331, eine Berechnungseinheit 333 und eine Steuereinheit 334.

In der Speichereinheit 332 ist ein digitaler Datensatz abgespeichert, der die grafische Form der partiellen Metallisierung definiert. Dieser digitale Datensatz wird von der Eingabeeinheit 331 erstellt und in der Speichereinheit 332 abgespeichert.

Die Eingabeeinheit 331 besteht aus einer Schnittstelleneinrichtung zum Empfang von Daten, beispielsweise über einen seriellen oder parallelen Bus oder über ein Rechnernetz. Es ist jedoch auch möglich, daß die Eingabeeinheit 331 ein grafisches Benutzerinterface umfaßt, mittels dem von einem Benutzer die grafische Form der partiellen Metallisierung spezifiziert werden kann.

Die Berechnungseinheit 333 berechnet aus dem in der Speichereinheit 332 abgespeicherten digitalen Datensatz eine zugeordnete Werkzeugbahn und Steuerdaten zur Ansteuerung eines Werkzeugs, um das Werkzeug gemäß der grafischen Form der partiellen Metallisierung zu führen und gemäß dieser grafischen Form eine digitale Demetallisierung durch das Werkzeug zu bewirken.

Die Steuereinheit 334 steuert basierend auf diesen berechneten Daten die Führungseinrichtungen 35 und 36 derart an, daß der Karbonstift 38 und der Folienkörper 30 relativ zueinander gemäß der Werkzeugbahn bewegt werden. Weiter steuert die Steuereinheit 334 das Schaltelement 34 während dieser Bewegung basierend auf diesen berechneten Daten derart an, daß der Karbonstift 38 gemäß der grafischen Form der partiellen Metallisierung eine partielle Demetallisierung der Metallschicht 31 durch Funkenerosion der Metallschicht 31 bewirkt.

Das Schaltelement 34 wandelt die Steuersignale der Steuereinheit 331 in Spannungsimpulse um, die dem Karbonstift 38 zugeführt werden. Das Steuerelement 34 besteht beispielsweise aus einer entsprechenden Transistorschaltung oder aus einem Relais.

Das Masse-Kontakt-Element 39 dient zur Herstellung eines galvanischen Kontaktes zwischen der Metallschicht 31 und der Spannungsquelle 40. Das Masse-Kontakt-Element 39 besteht beispielsweise aus einer oder mehreren Rollen aus einem leitfähigen Material, die gegen die Metallschicht 31 gepreßt werden.

Die Führungseinrichtung 35 besteht aus einem Servomotor mit der zugeordneten Regelelektronik, der den Karbonstift 38 quer zur Folienlängsrichtung bewegt. Die Führungseinrichtung 36 besteht ebenfalls aus einem Servomotor mit zugeordneter Regelelektronik, der eine Bewegung der Rolle 37 und damit eine Bewegung des Folienkörpers 30 in Längsrichtung bewirkt.

Der Karbonstift 38 wird in einem genau definierten Abstand über die Metallschicht 31 geführt. Es ist hierbei auch möglich, daß die Führungseinrichtung 35 eine entsprechende Regeleinrichtung enthält, die diesen Abstand ständig kontrolliert und nachregelt.

Der Abstand des Karbonstiftes 38 von der Metallschicht 31 beträgt vorzugsweise 0 bis 200µm.

Die Spannung der Spannungsquelle 40 beträgt vorzugsweise 3 bis 4 V, wenn die Metallschicht 31 aus Aluminium besteht. Die Spannung der Spannungsquelle 40 beträgt vorzugsweise etwa 6 V, wenn die Metallschicht 31 aus Chrom besteht.

Weiter ist es möglich, den Karbonstift 38 durch einen Stift aus einem anderen leitfähigen Material, beispielsweise aus Silber oder Kupfer, zu ersetzen.

Es ist auch möglich, daß der Karbonstift 38 von der Führungseinrichtung 35 nicht nur in Querrichtung, sondern auch in Längsrichtung bewegt werden kann. In diesem Falle wäre es auch möglich, auf die Führungseinrichtung 36 und die Rolle 37 zu verzichten. Der Karbonstift 38 könnte auch durch einen Laser ersetzt werden, der von dem Schaltelement 34 angesteuert ist und der die Metallschicht 31 durch Verdampfung erodiert.

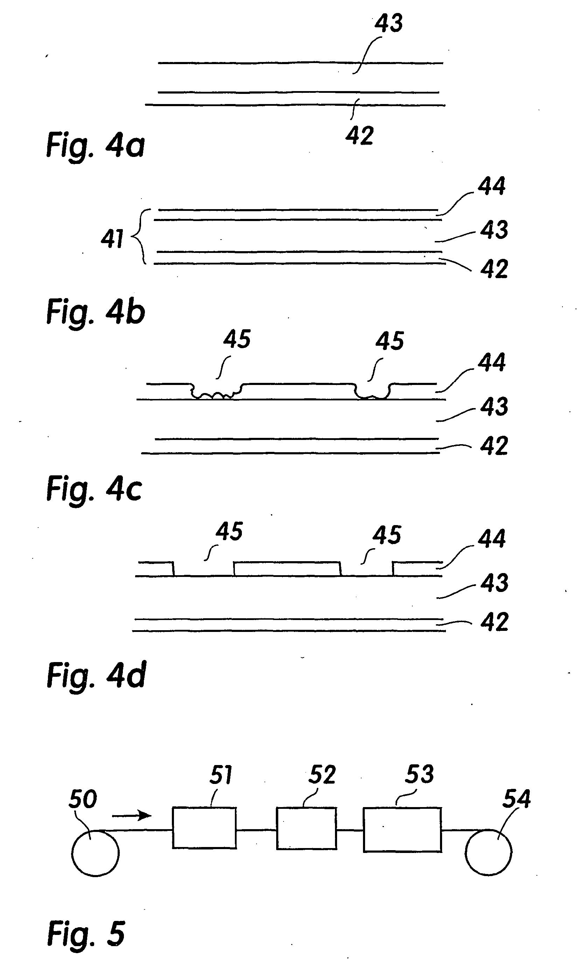

Anhand der Figuren 4a bis 4d und Fig. 5 wird nun ein weiteres Ausführungsbeispiel der Erfindung erläutert, bei dem eine partielle digitale Demetallisierung durch Auftragen eines Ätzmittels bewirkt wird.

Fig. 5 zeigt zwei Folienrollen 50 und 54 und drei Bearbeitungsstationen 51 bis 53.

Die Bearbeitungsstation 51 ist eine Metallisierungsstation, die wie die Metallisierungsstation 22 nach Fig. 2 ausgestaltet ist.

Der Bearbeitungsstation 51 wird die in Fig. 4a dargestellte Folie zugeführt, die aus einem Träger 42 und aus einem Foliengrundkörper 43 aufgebaut ist. Der Foliengrundkörper 43 kann beispielsweise aus den Schichten 12 bis 15 nach Fig. 1 bestehen. Es ist jedoch auch möglich, daß der Foliengrundkörper 43 aus einer einzigen Trägerschicht besteht.

Die Bearbeitungsstation 51 trägt auf den Foliengrundkörper 43 eine Metallschicht 44 auf. Der sich so ergebende Folienkörper 41 (Fig. 4 b) wird nun der Bearbeitungsstation 52 zugeführt.

Die Bearbeitungsstation 52 ist wie die Demetallisierungsstation 23 nach Fig. 2 ausgestaltet, mit dem Unterschied, daß das Masse-Kontakt-Element 39 und der Karbonstift 38 durch eine Einrichtung ersetzt sind, die ein Ätzmittel gemäß der Ansteuerung durch das Schaltelement 34 auf die Metallschicht 44 aufträgt. Vorteilhafterweise wird hierbei das Ätzmittel in Tröpfchenform auf die Metallschicht 44 aufgespritzt. Das von dem Steuerelement 34 angesteuerte Werkzeug umfaßt beispielsweise ein Piezoelement oder ein Verdampfungselement, das bei Anlegen eines Spannungsimpulses einen Druckimpuls in einer mit Ätzmittel gefüllten Kammer erzeugt und damit einen tröpfchenförmigen Ausstoß von Ätzmittel durch eine an der Kammer anschließende Düse verursacht.

Als Ätzmittel für ein derartiges Verfahren eignen sich Laugen oder Säuren, beispielsweise Natronlauge oder Kalilauge in einer Konzentration von 2 bis 10 Gewichtsprozenten.

Wie in Fig. 4c dargestellt, wird die Metallschicht 44 durch dieses Aufbringen eines Ätzmittels in Bereichen 45 demetallisiert.

Der derart bearbeitete Folienkörper 41 wird nun der Bearbeitungsstation 53 zugeführt, bei der es sich um eine Waschstation handelt, die Ätzmittelreste und Ätzmittelrückstände von dem Folienkörper 41 entfernt. In der Waschstation 53 wird der Folienkörper 41 beispielsweise durch ein oder mehrere mit einem Lösungsmittel gefüllte Becken bewegt und anschließend getrocknet.

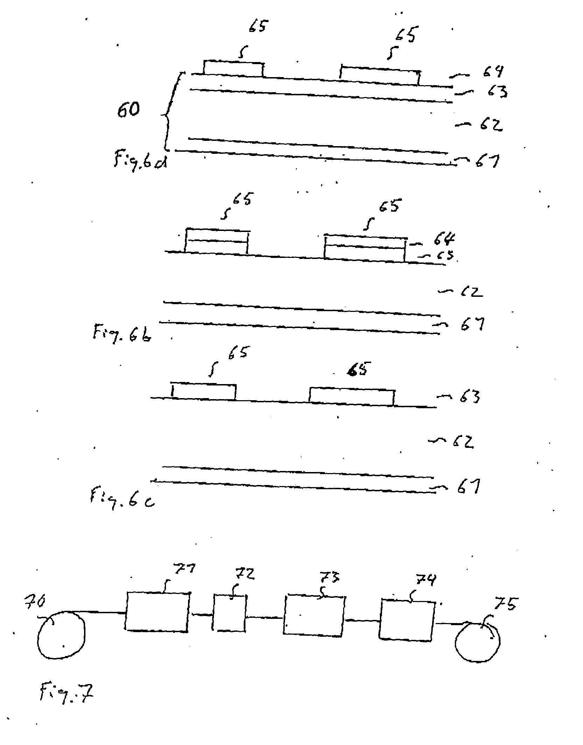

Anhand der Figuren 6a bis 6c und Fig. 7 wird nun ein weiteres Ausführungsbeispiel der Erfindung erläutert, bei dem eine digitale partielle Demetallisierung durch Auftragen eines Ätzresists bewirkt wird.

Fig. 7 zeigt zwei Folienrollen 70 und 75 sowie vier Bearbeitungsstationen 71 bis 74.

Die Bearbeitungsstation 71 ist wie die Bearbeitungsstation 52 ausgestaltet, mit dem Unterschied, daß anstelle eines Ätzmittels ein Ätzresist auf eine Metallschicht aufgespritzt wird. Wie in Fig. 6a dargestellt, wird auf einen Folienkörper 60, der einen Träger 61, einen Foliengrundkörper 62 und eine Metallschicht 63 umfaßt, in Bereichen 65 ein Ätzresist 64 aufgespritzt.

Der Ätzresist 64 besteht aus einem der folgenden Materialien: PVC, Acrylaten, Polyamiden, UV-Acrylaten, Polyurethane.

Es ist hierbei auch möglich, daß der Ätzresist 64 nicht auf die Metallschicht 63 aufgespritzt wird, sondern auf die Metallschicht 63 mittels einer Rolle übertragen wird. Beispielsweise ist es möglich, daß ein pulverförmiger Ätzresist mittels Wärmeeinwirkung nach Art eines Laserdruckers oder durch ein elektroxerografisches Verfahren partiell auf die Metallschicht 63 aufgebracht wird.

Die Folie wird sodann der Bearbeitungsstation 72 zugeführt, bei der es sich um eine thermische Behandlungsstation handelt, die ein Aushärten des Ätzresists 64 bewirkt. Auf die Bearbeitungsstation 72 kann je nach Wahl des Ätzresists auch verzichtet werden.

Anschließend wird die Folie der Bearbeitungsstation 73 zugeführt, bei der es sich um eine Demetallisierungsstation handelt. In dieser Bearbeitungsstation wird die Metallschicht 63 in den nicht durch den Ätzresist 64 geschützten Bereichen mittels beispielsweise einer Säure oder einer Lauge entfernt. Wie in Fig. 6b dargestellt, weist die Folie somit nach Bearbeitung durch die Bearbeitungsstation 73 nur in den Bereichen 65 die nun partielle Metallschicht 63 auf.

Besonders vorteilhaft ist es, bereits vorhandene oder vorgedruckte Bildinformationen, wie alphanumerische oder holografische diffraktive oder Farbinformationen, registerhaltig mit Ätzresist zu versetzen und so eine passergenaue Metallisierung oder Demetallisierung im Nachfolgeprozeß zu ermöglichen.

Anschließend wird die Folie der Bearbeitungsstation 74 zugeführt. Die Bearbeitungsstation 74 ist eine Waschstation, die die Ätzresistschicht 64 mittels eines Lösungsmittels entfernt und die Folie anschließend trocknet.

Es ist jedoch auch möglich, die Folie nicht der Bearbeitungsstation 74 zuzuführen und die Ätzresistschicht 64 auf der Folie zu belassen. Dieses Vorgehen hat sich als vorteilhaft erwiesen, da die Ätzresistschicht 64 als Haftvermittlungsschicht für weiter aufzubringende Schichten verwendet werden kann. Die Schicht 64 erfüllt somit eine Doppelfunktion, die Funktion einer Ätzresistschicht und einer Haftvermittlungsschicht.

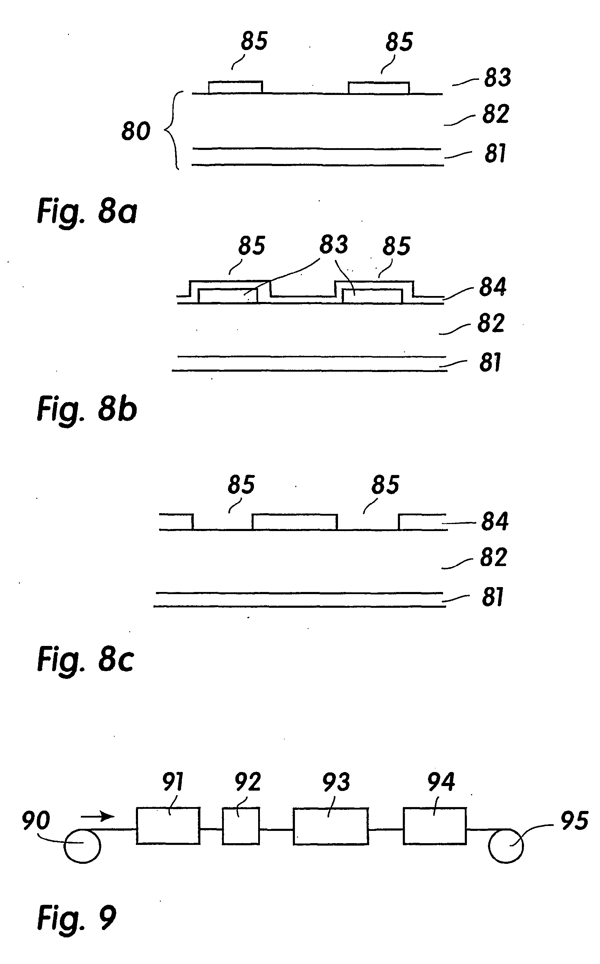

Anhand der Figuren 8a bis 8c und Fig. 9 wird nun ein weiteres Ausführungsbeispiel der Erfindung erläutert, bei dem die digitale Demetallisierung mittels Auftragen einer Waschmaske bewirkt wird.

Fig. 9 zeigt zwei Folienrollen 90 und 95 und vier Bearbeitungsstationen 91 bis 94.

Der Bearbeitungsstation 91 wird die in Fig. 8a gezeigte Folie zugeführt, die aus einem Folienkörper 80, bestehend aus einem Foliengrundkörper 82 und einem Träger 81, aufgebaut ist. Der Foliengrundkörper 82 ist wie der Foliengrundkörper 43 nach Fig. 5 aufgebaut.

Die Bearbeitungsstation 91 ist wie die Bearbeitungsstation 71 nach Fig. 7 aufgebaut, mit dem Unterschied, daß die Bearbeitungsstation 91 anstelle eines Ätzresists eine Waschmaske auf dem Folienkörper 80 aufbringt. Wie in Fig. 8a dargestellt, trägt die Bearbeitungsstation 91 auf dem Folienkörper 80 in Bereichen 85 eine Waschmaske 83 auf. Die Waschmaske 83 besteht vorzugsweise aus einer Polymer-basierten Waschmaske. Als Materialien für eine Waschmaske können beispielsweise Methylcellulose, Carboxymethylcellulose, das Natriumsalz der Polyacrylsäure oder Polyvinylpyrrolidon, daneben Polyzucker und andere native Materialien verwendet werden, die sowohl filmbilden als auch wasserlöslich sind.

Anschließend wird die Folie der Bearbeitungsstation 92 zugeführt, die ein Aushärten der Waschmaske 83 durch Trocknung bewirkt. Auf die Bearbeitungsstation 92 könnte hierbei auch verzichtet werden.

Anschließend wird die Folie der Bearbeitungsstation 93 zugeführt, bei es sich um eine Metallisierungsstation handelt und die, wie in Fig. 8b dargestellt, auf den zugeführten Folienkörper eine Metallschicht 84 aufträgt. Die Bearbeitungsstation 93 kann hierbei wie die Bearbeitungsstation 51 nach Fig. 5 ausgestaltet sein.

Anschließend wird die Folie der Bearbeitungsstation 94 zugeführt, bei der es sich um eine Waschstation handelt. Hier wird durch Waschen und anschließendes Trocknen die Waschmaske 83 und die über dieser Schicht liegenden Bestandteile der Metallschicht 84 entfernt, wodurch die in Fig. 8c gezeigte Folie entsteht, bei der in den Bereichen 85 die Metallschicht 84 partiell entfernt ist.

## Patentansprüche

1. Verfahren zur Herstellung einer partiell metallisierten Präge-, Inmould- oder Laminierfolie,
**dadurch gekennzeichnet,**
**dass** ein digitaler Datensatz (332) erstellt wird, der die grafische Form der partiellen Metallisierung definiert, dass aus dem digitalen Datensatz (332) eine Werkzeugbahn und Steuerdaten zur Ansteuerung eines Werkzeugs berechnet werden (333), dass das Werkzeug (38) und ein ein- oder mehrschichtiger Folienkörper (30, 41, 60, 80) relativ zueinander gemäß der Werkzeugbahn bewegt werden und dass das Werkzeug (38) gesteuert durch die Steuerdaten eine partielle digitale Demetallisierung einer Metallschicht (16, 31, 44, 63, 84) **dadurch** ermöglicht, dass von dem Werkzeug eine Waschmaske (83) zur partiellen Abdeckung des ein- oder mehrschichtigen Folienkörpers (80) durch Aufspritzen aufgetragen wird (91), der ein- oder mehrschichtige Folienkörper (80) anschließend getrocknet, mit der Metallschicht (84) versehen und die Metallschicht (84) durch ein Waschverfahren im Bereich der Waschmaske (83) partiell entfernt wird (94).

2. Verfahren zur Herstellung eines partiell metallisierten Folienelementes (1) nach Anspruch 1,
**dadurch gekennzeichnet,**
**dass** die Waschmaske registerhaltig zu bereits vorhandenen oder vorgedruckten Bildinformationen aufgebracht wird.

3. Verfahren zur Herstellung eines partiell metallisierten Folienelements (1) nach Anspruch 1,
**dadurch gekennzeichnet,**
**dass** die Metallschicht (16, 31, 44, 63, 84) eine Dicke kleiner als 1 µm besitzt.

4. Verfahren zur Herstellung eines partiell metallisierten Folienelements (1) nach Anspruch 1,
**dadurch gekennzeichnet,**
**dass** die Metallschicht (16, 31, 44, 63, 84) vollflächig aufgebracht wird, insbesondere durch Aufdampfen vollflächig aufgebracht wird.

5. Verfahren zur Herstellung eines partiell metallisierten Folienelements (1) nach Anspruch 1,
**dadurch gekennzeichnet,**
**dass** die Metallschicht partiell aufgebracht wird.

## Claims

1. Method for producing a partially metallized embossing film, inmould film or laminating film, **characterized in that** a digital data set (332) which defines the graphic form of the partial metallization is compiled, **in that** a tool path and control data for driving a tool are calculated (333) from the digital data set (332), **in that** the tool (38) and a single-layer or multilayer film body (30, 41, 60, 80) are moved relative to each other according to the tool path and **in that** the tool (38), controlled by the control data, enables a partial digital demetallization of a metal layer (16, 31, 44, 63, 84) by way of the tool applying (91), by means of spraying, a washing mask (83) for partially covering the single-layer or multilayer film body (80), the single-layer or multilayer film body (80) subsequently being dried, being provided with the metal layer (84) and the metal layer (84) being partially removed in the region of the washing mask (83) by means of a washing method.

2. Method for producing a partially metallized film element (1) according to Claim 1, **characterized in that** the washing mask is applied in register with any image information that is already present or has already been printed.

3. Method for producing a partially metallized film element (1) according to Claim 1, **characterized in that** the metal layer (16, 31, 44, 63, 84) has a thickness of less than 1 µm.

4. Method for producing a partially metallized film element (1) according to Claim 1, **characterized in that** the metal layer (16, 31, 44, 63, 84) is applied over the whole area, in particular is applied over the whole layer by way of vapour deposition.

5. Method for producing a partially metallized film element (1) according to Claim 1, **characterized in that** the metal layer is partially applied.

## Revendications

1. Procédé de production d'une feuille estampée, moulée ou stratifiée, partiellement métallisée, **caractérisé en ce que**
un jeu de données numériques (332) est produit, qui définit la forme graphique de la métallisation partielle, qu'à partir du jeu de données numériques (332), une trajectoire d'outil et des données de commande sont calculées (333) pour commander un outil, que l'outil (38) et un corps de feuille mono- ou multicouche (30, 41, 60, 80) sont déplacés l'un par rapport à l'autre selon la trajectoire d'outil et que l'outil (38) commandé par les données de commande permet une démétallisation numérique partielle d'une couche métallique (16, 31, 44, 63, 84) par le fait que par l'outil, un masque de lavage (83) est appliqué (91) pour assurer un revêtement partiel du corps de feuille mono- ou multicouche (80) par pulvérisation, le corps de feuille mono- ou multicouche est ensuite séché, doté de la couche métallique (84) et la couche métallique (84) est retirée partiellement (94) par un procédé de lavage dans la zone du masque de lavage (83).

2. Procédé de production d'un élément de type feuille partiellement métallisé (1) selon la revendication 1, **caractérisé en ce que**
le masque de lavage est appliqué en repérage d'informations d'image déjà présentes ou pré-imprimées.

3. Procédé de production d'un élément de type feuille partiellement métallisé (1) selon la revendication 1, **caractérisé en ce que** la couche métallique (16, 31, 44, 63, 84) possède une épaisseur inférieure à 1 µm.

4. Procédé de production d'un élément de type feuille (1) partiellement métallisé selon la revendication 1, **caractérisé en ce que**
la couche métallique (16, 31, 44, 63, 84) est appliquée sur toute la surface, en particulier par évaporation sur toute la surface.

5. Procédé de production d'un élément de type feuille partiellement métallisé (1) selon la revendication 1, **caractérisé en ce que**
la couche métallique est partiellement appliquée.
